# EUROPEAN PATENT SPECIFICATION

(11) **EP 0 660 329 B1**
(45) Date of publication and mention of the grant of the patent: **09.04.2003**
(21) Application number: 94309204.9
(22) Date of filing: 09.12.1994
(51) Int. Cl.: G11C 7/00, G11C 11/409

(54) **Variable latency, output buffer and synchronizer for synchronous memory**
Ausgangpuffer mit variabler Latenz und Synchronisiereinrichtung für synchronen Speicher
Tampon de sortie à latence variable et synchroniseur pour mémoire synchrone

(30) Priority: 16.12.1993 US 167044; 16.12.1993 US 167489
(43) Date of publication of application: 28.06.1995
(73) Proprietor: Mosaid Technologies Incorporated, Kanata, Ontario K2K 1X6 (CA); FUJITSU LIMITED, Kawasaki-shi, Kanagawa 211 (JP)
(72) Inventor: Wojcicki, Tomasz, Kanata, Ontario, K2K 2P1 (CA); Allan, Graham, Stittsville, OntarioK2S 1E4 (CA); Larochelle, Francis, Hull, Quebec, J9A 2V5 (CA)
(74) Representative: O'Connell, David Christopher

(56) References cited:
- EP-A- 0 487 288
- EP-A- 0 511 408

## Description

### FIELD OF THE INVENTION

This invention relates to semiconductor memory circuits, and in particular to an output buffer and to a latency control circuit for a random access memory circuit such as a synchronous dynamic random access memory (SDRAM) circuit.

### BACKGROUND TO THE INVENTION

A description of SDRAMs may be found in the article "Synchronous DRAMs: Designing to the JEDEC Standard", in MICRON Design Line, volume 2, Issue 2, No 2Q93, and in European patent application 0 511 408 A1 filed 19 November 1991.

Synchronous DRAMs can utilize different column access select (CAS) latency modes of operation. For example, for a CAS latency of one, data which is read by its data bus read amplifier arrives at its output buffer after the clock signal. For a CAS latency of three, the data waits for the clock signal at a stage preceding the output buffer. For a latency of two there is a race condition between the data and the clock to the output buffer.

In a standard DRAM driven by RAS/CAS signals, it was always certain that its output buffer would be put into a tri-state mode when /CAS was at high logic level. On the falling edge of the /CAS signal, new data would be driven to the output pin for the output tristate driver. If the data had not yet arrived, the output of the tristate driver would remain at an intermediate logic level until data was available.

In SDRAMs operating at high speeds of e.g. 100 MHz or higher, there is no time for the tristate driver to enter the intermediate level between data pulses that it outputs. The output buffer must switch virtually instantaneously between one logical polarity of binary data pulses to the other.

### SUMMARY OF THE INVENTION

The present invention provides an output buffer for an SDRAM which can operate at the aforenoted high speeds, provides an output driver signal between two polarities of binary logic levels, and can be driven from data signals that have any of the aforenoted latencies of one, three or two, that is, wherein the data signals arrive after the clock, arrives before the clock, and is in a race with the clock, respectively.

In accordance with an embodiment of the invention, an output buffer for driving an output driver of a random access memory (RAM) circuit to either of opposite binary data values from a data source and a clock wherein the relative timing of data and clock signals is variable or uncertain, comprising a source of data signals, a source of clock signals having pulses one of which has a rising edge either being earlier than a leading edge of a data pulse, being later than the leading edge of the data pulse, or being in a race condition with the data pulse, a latency counter for receiving the clock signals and for outputting a latent control signal, apparatus for summing the latent control signal and the data pulse, and apparatus for providing a signal to an output driver from the summing means which is in sync with the latent control signal.

The present invention also provides a variable latency circuit that reads the data logic level on the SDRAM databus leads, and presents it to the output buffer in a manner in which the latency is automatically adjusted, and the data can be always output from the output buffer in synchronization with the clock, and always following the leading edge of a clock cycle, with the proper delay so that it follows the leading edge of a first clock pulse for a latency of one, it follows the leading edge of a second clock pulse for a latency of two, and follows the leading edge of a third clock pulse for a latency of three.

In accordance with an embodiment of the invention, a variable latency output circuit for a synchronous dynamic random access memory (SDRAM) is comprised of a circuit for reading complementary data bus lines, a circuit for receiving an output signal of the reading circuit, an output buffer for receiving an output signal of the receiving circuit and for providing an output signal to an output driver, a latency counter for receiving and counting a clock signal and for providing an output enable signal to the output buffer for outputting the output signal upon counting a predetermined number of clock pulses based on a predetermined latency, and a circuit for enabling the reading circuit, the receiving circuit and the output buffer to pass data logic levels from the data bus lines to the output driver within one clock cycle in the event of a latency of one, for delaying the data logic levels for one clock cycle in the event of a latency of two, and for delaying the data logic levels for two clock cycles in the event of a latency of three.

### BRIEF INTRODUCTION TO THE DRAWINGS

A better understanding of this invention will be obtained by a consideration of the detailed description below, with reference to the following drawings, in which
Figure 1 is a logic diagram of a preferred embodiment of the invention,
Figure 2 is a one case of timing diagram of signals, used to describe operation of an embodiment of the invention,
Figure 3 is another one case of timing diagram of signals, used to describe operation of an embodiment of the invention,
Figure 4 is a logic diagram of a driver circuit that can be used with the invention,
Figure 5 is a timing diagram used to explain the operation of the driver circuit of Figure 4,
Figure 6 is a block diagram of the invention,
Figure 7 is a schematic diagram of a databus control and output buffer portion of the invention,
Figures 8 and 9 are timing diagrams of the circuit of Figure 7,
Figure 10 is a schematic diagram of the read amplifier and driver stage portion of the invention, and
Figures 11, 12 and 13 are timing diagrams of circuit of Figure 10.

### DETAILED DESCRIPTION OF THE PREFERRED EMBODIMENT

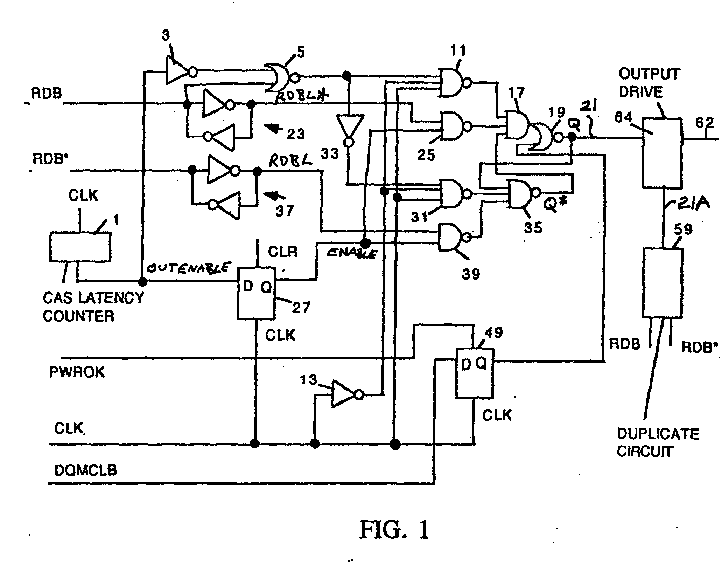

With reference to Figure 1, binary data is received at the RDB and RDB* inputs from a databus sense amplifier of the SDRAM.

A clock signal CLK is received elsewhere in the SDRAM in a CAS latency counter 1, which has been set from an external control to the desired latency value. The counter 1 will therefore either allow the control signals to pass through without delay, will delay them by one clock pulse, or will delay them by two clock pulses, to provide latencies of 1, 2 or 3 respectively. The output of the CAS latency circuit 1 is referred to herein as a latent control signal OUTEN. The clock pulses are also applied to other output buffer circuits.

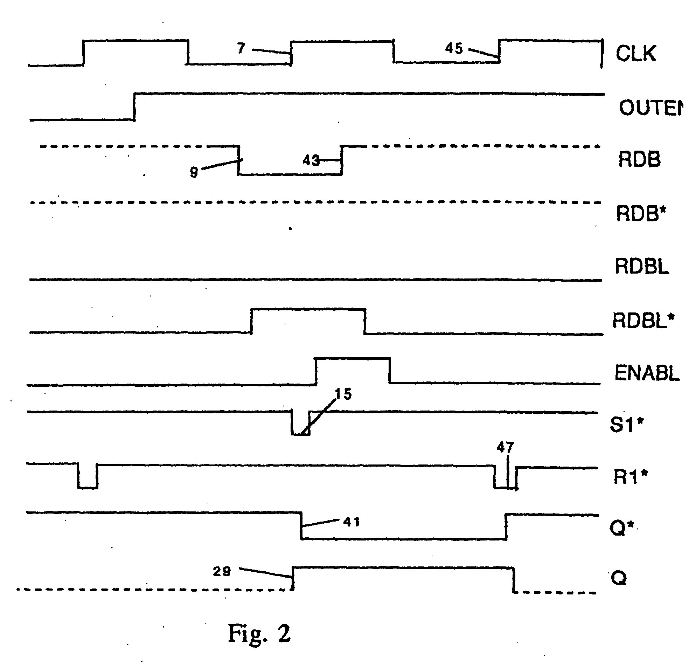

Turning now also to Figure 2, which is a timing diagram of signals for the case in which the data is received prior to the clock, the first signal shown is the CLK signal, which has regular clock pulses. At a particular time, the CAS latency circuit has counted to a predetermined latency value, and a latent control signal OUTEN is provided. That signal, inverted in inverter 3, is applied to an input of NOR gate 5. The ENABLE signal is at low logic level, disabling gates 25 and 39. The data can pass only via gate 11 or 39.

As may be seen from Figure 2, at a time prior to the rising edge 7 of a clock pulse, the leading edge 9 of a negative logic level data pulse RDB appears, which is applied to the other input of NOR gate 5. With the OUTEN signal at high logic level which causes the input to gate 5 to be at low logic level from inverter 3 and RDB at low logic level, the gate 5 changes its output to a high logic level, and applies this logic level to an input of NAND gate 11.

When the CLK signal goes to high logic level at the time of leading edge 7, another input to NAND gate 11 goes to high logic level from the CLK input. The CLK signal is also applied to inverter 13. Prior to its application to that inverter, its output is at high logic level. Thus at that point all three inputs to NAND gate 11 are at high logic level, and its output thus drops to low logic level. When the CLK signal is applied to inverter 13, it takes a short period of time to pass the signal, and then its output goes to low logic level, which is received by one of the inputs of NAND gate 11. The result, at the output S1 of NAND gate 11, is a short low logic level pulse 15, shown in timing diagram S1.

The pulse output of NAND gate 11 is applied through AND gate 17 (and NOR gate 19 if it is used), to output terminal 21 (timing diagram Q), from where it is applied to an output driver at output Q.

Gates 17, 19 and 35 form a latch. If the leading edge of a data pulse arrives before a leading edge of a clock pulse, the aforenoted path is not used. The latch formed of gates 17, 19 and 35 is set by the S1* pulse 15. The ENABLE signal is still low, and disable gate 25 at the time of the S1* pulse 15. The output of gate 25 goes low after the pulse 45, but this is irrelevant for the operation of the circuit.

The negative-going signal is also applied to NAND gate 31, with the positive-going signal level at the output of NOR gate 5 inverted in inverter 33. This causes output R1* of gate 31 to remain at high logic level, which is input to NAND gate 35. With the other data line RDB* stable at high logic level, applied through cross-coupled inverters 37, and applied to an input of NAND gate 39 with the ENABLE signal, NAND gate receives the high logic level R2* at its output. Another input of NAND gate 35 receives the output signal from Q. NAND gate 35 is cross coupled with AND gate 17, and the output at Q causes the output Q* of NAND gate 35 to go to low logic level, with leading edge 41 and latches the RDB data in the cross-coupled NAND gates 17 and 35.

The data pulse RDB eventually goes high, at trailing edge 43. This causes the signal on the RDBL* lead to go to low logic level. The result is that at the next rising leading edge 45 of the CLK signal, there is a low level temporary pulse 47 created at the output of the gate 31 from the CLK and inverted CLK signals, which passes into gate 35, which interrupts the latching effect of gates 17 and 35, which causes the Q* signal to go to high logic level, and once unlatched, the signal at Q to go to low logic level.

It should be noted that an external control can be provided for use by a user to control the operation of the output tri-state buffer by disabling the Q terminal. This can be provided by the use of NOR gate 19, which can be deleted if this user control is not desired. The second input of gate 19 has an input from flip flop 49, which is synchronized by clock signal CLK, and has a data input from user input DQMCLB.

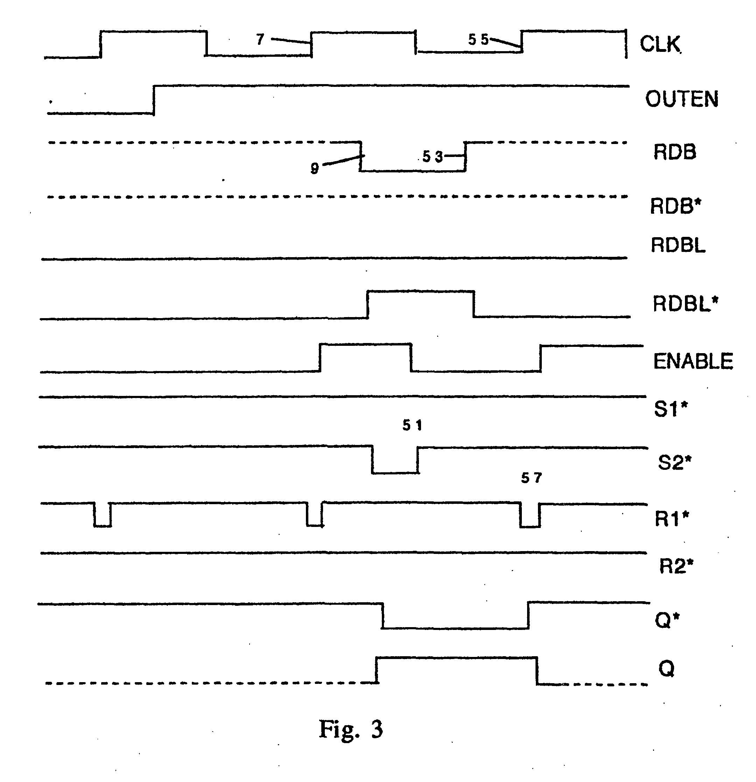

Turning now to Figure 3, a timing diagram is shown in the case of data leading edge 9 on the RDB lead arriving after the leading edge 7 of the clock pulse, e.g. latency 1. With the RDB data going low coincident with the CLK signal being at high logic level, the RDBL* level goes to high level. Now with the ENABLE signal being high due to the latency counter having counted to an appropriate value and therefore outputting a high level output signal earlier than in the previous example, causing the ENABLE signal to be high, the RDBL* signal being high with the ENABLE signal and applied to the inputs of gate 25, gate 25 outputs the low logic signal 51 shown in Figure 3. This passes through gate 17 (and gate 19, if used), and appears on output Q, as output signal Q shown in Figure 3.

The signal is enabled to pass through gate 17 because all its other inputs are at high logic level during this interval. The CLK input to gate 11 is high, the OUTEN signal is high and is inverted in inverter 3 during this interval. With the CLK signal being high and applied to inverter 13, the output of inverter 13 is low causes gate 11 to output a high logic level signal. The ENABLE signal being at high level as described above is applied to gate 39 with the low level RDBL signal, causing gate 35 to be enabled and go to low logic level as shown by waveform Q*, with the output signal Q at pin 21 having gone to high logic level. Gates 17 and 19 thus latch.

The data signal RDB then goes to high level at the trailing edge 53. The RDBL* signal thus goes to low level. The circuit then waits for the next leading edge 55 of the CLK signal, and when the pulse 57 resulting therefrom arrives, gate 31 displays this pulse at its output R1*, causing gate 35 to release the latch, and first the signal Q* at the output of gate 35 goes to high level, and then as a result, the signal Q goes to low level.

Thus it has been seen how the drive terminal Q has been driven to high level and low level by both the conditions of the data from the databus read amplifier arriving before the clock, and with the data arriving after the clock. It will also be seen that the signal at the drive terminal has been synchronized with the clock. In the case of a race condition (latency 2), one or the other of the conditions noted above will occur, but the output drive terminal will still be driven high and low, and synchronized, no matter which condition occurs.

The above-described circuit is duplicated and works similarly as described above, the duplicate circuit being shown as reference numeral 59. Two circuits are used in order to respectively pull the output 62 of a driver circuit up and down respectively.

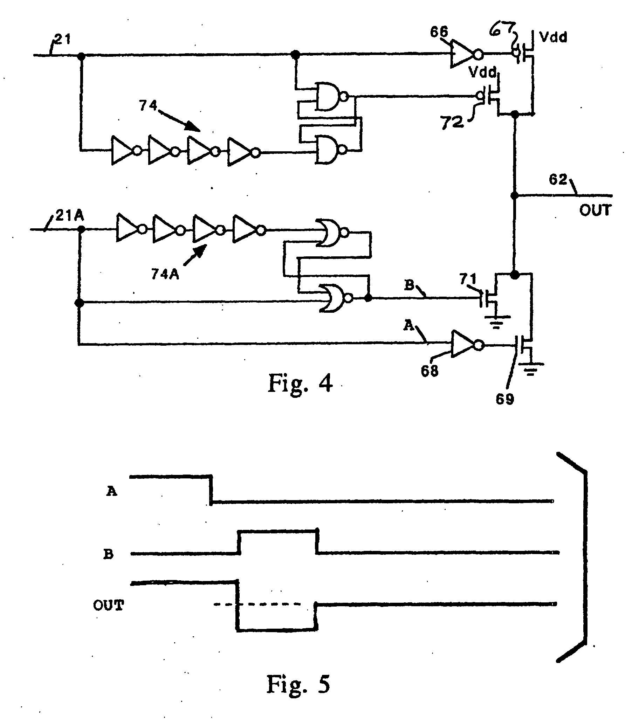

Figure 4 is a logic diagram of a driver circuit that can be used. Output terminal 21 and corresponding terminal 21A are input to n and p channel output field effect devices. Terminal 21 is connected through inverter 66 to the gate of p channel device 67, which has its drain and source connected between voltage source Vdd and the output 62 of the driver circuit. Terminal 21A is connected through an inverter 68 to the gate of an n channel device 69, which has its source and drain connected between ground and the output 62.

In order to provide a higher strength drive to occur, extra transistors 71 and 72 of similar polarities as transistors 67 and 69 have their sources and drains connected in parallel with transistors 67 and 69. Each of transistors 71 and 72 is driven from a pair of cross-connected AND gates which are driven from output terminal 21 and output terminal 21A respectively, and from delayed representations of the signals on those terminals, which delays are provided by the series of inverters 74 and 74A respectively.

In operation, considering now Figure 5, when the drive to inverter 68 goes to low logic level, and the delayed drive to transistor 71 goes high, the output signal on output 62 goes from high logic level to low logic level while both transistors 69 and 71 are enabled, then to a higher low logic level following that interval, when only one transistor 69 is enabled. The purpose of driving both transistors for a short interval (controlled by the delay in inverters 74 and 74A), to a very high level is to obtain a higher slew rate than if only a single transistor were driven.

This driving circuit can operate in several modes. For example, with the circuit just described, it can drive e.g. a 50 ohm load in a symmetrical manner. It can alternatively be driven with the p channel transistors disabled, thus causing the n channel devices to have open drains. Thus to provide the first mode, the output terminal is connected to the circuit just described. To provide the second mode, it is open circuited, and the conductor connected to the input of inverter 66 is grounded.

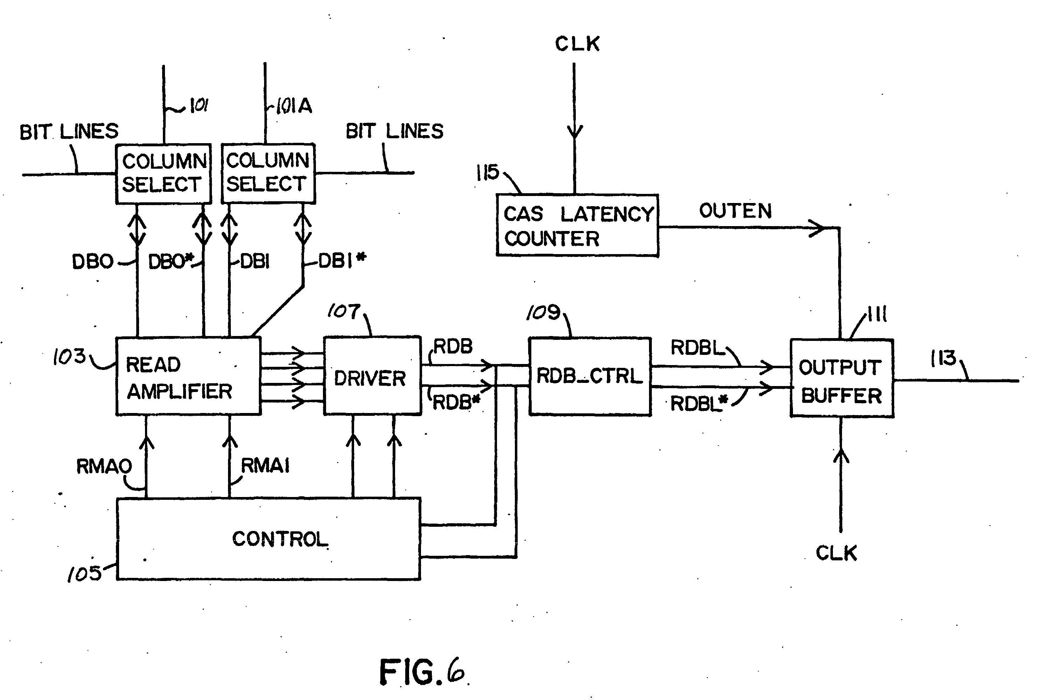

Turning now to Figure 6, a block diagram of an embodiment of the invention is shown. A pair of column select circuits 101 and 101A of well known construction apply data logic levels each to a pair of databuses DB0 and DB0* and DB1 and DB1* respectively after having columns decoded, the data logic levels having been sensed in sense amplifiers from bit storage cells associated with the bit lines. The data buses are read in read amplifiers upon receiving respective enable signals RMA0 and RMA1 from a control circuit 105. In accordance with an embodiment of this invention, the read amplifiers are formed as two portions, an amplifier stage 103 and a driver stage 107.

The RDB and RDB* outputs of the driver stage 107 are applied to a read databus control circuit 109 (RDB_CTRL), which provides outputs RDBL and RDBL* to an output buffer 111. Output buffer 111 outputs a driver output signal on output lead 113.

A clock source CLK is received by a CAS latency counter 115, which has an output OUTEN that is input to output buffer 111.

As noted earlier, synchronous DRAMs can utilize different CAS latency modes of operation. For example, for a CAS latency of one, data which is read by the data bus read amplifier arrives at the output buffer after the clock. For a CAS latency of three, the data is available before the clock. For a latency of two there is a race condition between the data and the clock to the output buffer.

The latency counter counts clock pulses, and outputs a signal that goes to high logic level after a predetermined number of clock cycles. With a latency of one, the OUTEN signal goes to high logic level during the initial pulse of a clock cycle wherein the data to be output is read during the same clock cycle. With a latency of two or three, the OUTEN signal goes high during a clock cycle which precedes the data that is to be output by one clock cycle. Once counter 115 has counted to the latency value, it outputs a consistently high level signal OUTEN.

To handle a latency of one, the data read by read amplifier is output through driver 107, RDB_CTRL circuit 109 and the output buffer 111 without delay, but synchronized with the clock signal CLK, and with the OUTEN signal high, is output to lead 113 in synchronization with the clock.

To handle a latency of two and eliminate the race condition, the data is passed from read amplifier 103 and driver 107 to RDB_CTRL circuit 109, where it is stored for one clock cycle, in order to delay it to a time later than the leading edge of the second clock cycle. With the OUTEN signal high, upon receiving the next clock cycle on the CLK lead, the output buffer outputs the data signal on the lead 113 in synchronism with the clock.

To handle a latency of three, the data is stored in a latch in read amplifier 103 for one clock pulse, then passes the data to the latch in the RDB_CTRL circuit where it is stored for one clock pulse, and upon receiving the next clock cycle, outputs the data on the lead 113 in synchronism with the clock.

Since for latency three (or in some cases of latency two) the data is received prior to the beginning of a clock cycle, the effect of the above is to output the data in synchronism with and during the third (second) clock cycle. While for a latency of one the data is output in synchronism with and during the first clock cycle.

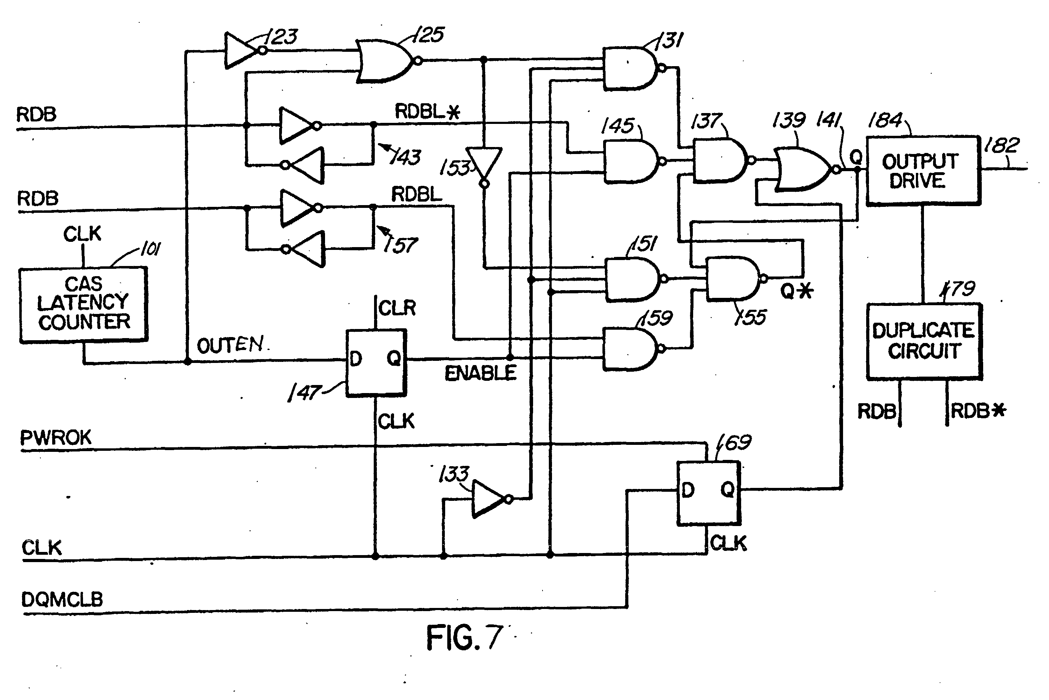

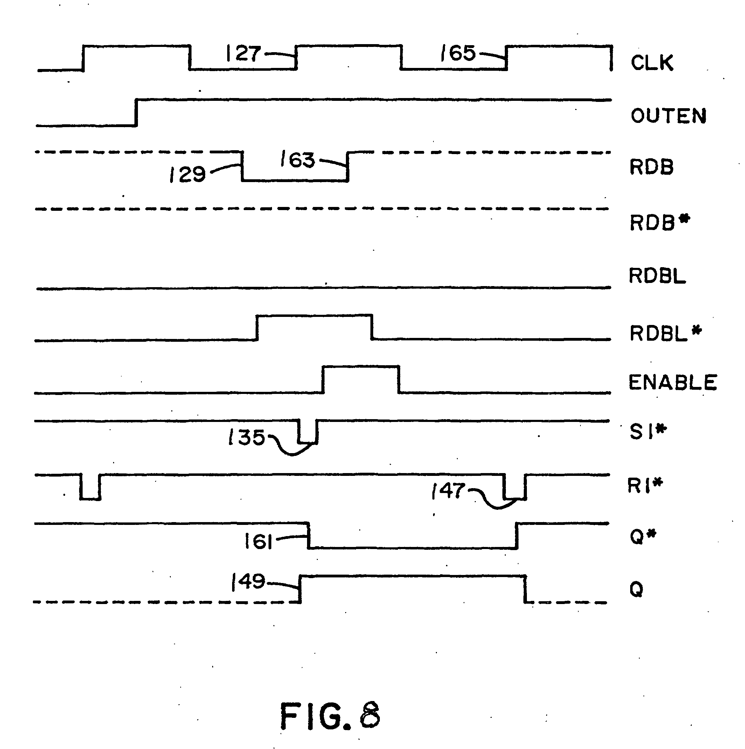

Reference is now made to Figure 7, which is a logic diagram of the RDB_CTRL circuit 109 and of the output buffer 111, as well as to the timing diagram illustrated in Figure 8, which is a timing diagram of signals for the case in which the data is received prior to the clock. The first signal shown is the CLK signal, which has regular clock pulses. At a particular time, the CAS latency circuit has counted to a predetermined latency value, and a high logic level output signal OUTEN is provided as noted earlier. That signal is inverted in inverter 123 and is applied to an input of NOR gate 125.

As may be seen from Figure 8, at a time prior to the rising edge 127 of a clock pulse, the leading edge 129 of a negative logic level data pulse RDB appears, which is applied to the other input of NOR gate 125. With the OUTEN signal at high logic level which causes the input to gate 125 to be at low logic level from inverter 123 and RDB at low logic level, the gate 125 changes its output to a high logic level, and applies this logic level to an input of NAND gate 131.

When the CLK signal goes to high logic level at the time of leading edge 127, another input to NAND gate 131 goes to high logic level from the CLK input. The CLK signal is also applied to inverter 133. Prior to its application to that inverter, its output is at high logic level. Thus at that point all three inputs to NAND gate 131 are at high logic level, and its output thus drops to low logic level. When the CLK signal is applied to inverter 133, it takes a short period of time to pass the signal, and then its output goes to low logic level, which is received by one of the inputs of NAND gate 131. The result, at the output S1 of NAND gate 131, is a short low logic level pulse 135, shown in timing diagram S1*.

The pulse output of NAND gate 131 is applied through AND gate 137 (and NOR gate 139 if it is used), to output terminal 141 (timing diagram Q), from where it is applied to an output driver at output Q.

The low logic level data signal RDB is caused to pass through gate 137 as follows. The data signal passes through cross-coupled inverters 143, where it is latched. it is also applied to an input of NAND gate 145. The high logic level OUTEN signal is applied to flip flop 147, which is clocked with the CLK signal, the Q output of which (see the ENABLE timing diagram) is applied to the other input of NAND gate 145.

The negative level of the RDB is also applied to NAND gate 151 (inverted in NOR gate 125 and inverter 153). This causes output R1* of gate 151 to remain at high logic level, which is input to NAND gate 155. With the other data line RDB* stable at high logic level, applied to cross-coupled inverters 157, where the data is latched. It is also applied to an input of NAND gate 159 with the ENABLE signal, and NAND gate 155 receives the high logic level R2* at its input. Another input of NAND gate 155 receives the output signal at Q. NAND gate 155 is cross coupled with AND gate 137, and the output at Q causes the output Q* of NAND gate 155 to go to low logic level, with leading edge 161.

The data pulse RDB eventually goes high, at trailing edge 163. This causes the signal on the RDBL* lead to go to low logic level. The result is that at the next rising leading edge 165 of the CLK signal, there is a low level temporary pulse 147 created at the output of the gate 151, which interrupts the latching effect of gates 137 and 155, which causes the Q* signal to go to high logic level, and once unlatched, the signal at Q to go to low logic level.

It should be noted that an external control can be provided for use by a user to control the operation of the output tri-state buffer by disabling the Q terminal. This can be provided by the use of NOR gate 139, which can be deleted if this user control is not desired. The second input of gate 139 has an input from flip flop 169, which is synchronized by clock signal CLK, and has a data input from user input DQMCLB.

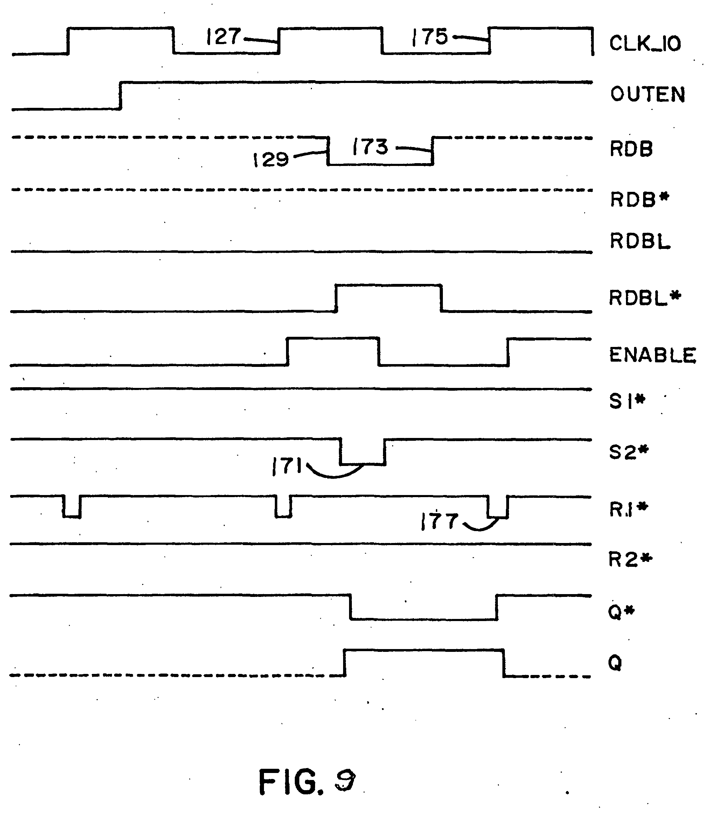

Turning now to Figure 9, a timing diagram is shown in the case of data leading edge 129 on the RDB lead arriving after the leading edge 127 of the clock pulse, e.g. latency of one. With the RDB data going low coincident with the CLK signal being at high logic level, the RDBL* level goes to high level. Now with the ENABLE signal being high due to the latency counter having counted to a proper value the inputs of gate 145 are high, gate 145 outputs the low logic signal 171 shown in Figure 8. This passes through gate 137 (and gate 139, if used), and appears on output Q, as output signal Q shown in Figure 9.

The signal is enabled to pass through gate 137 because all of its inputs are at high logic level during this interval. The CLK inputs to gate 131 are high, the OUTEN signal is high and is inverted in inverter 123 during this interval and with the RDB signal being low and applied to gate 125, the output of gate 125 is low causes gate 131 to output a high logic level signal. The output signal of gate 125 being inverted in inverter 153 causes the output of gate 151, which also receives signals CLK and inverted CLK pulses with each rising clock edge, creates pulses each rising clock edge, and is at high logic level during the inter-pulse interval, and with the output signal from gate 125 being inverted in inverter 153 being applied, the output of gate 151 is at high logic level. The ENABLE signal being at high level as described above is applied to gate 159 with the low level RDBL signal, causing gate 155 to be enabled and go to low logic level as shown by waveform Q*, with the output signal Q at lead 141 having gone to high logic level. Gates 137 and 139 thus latch.

The data signal RDB then goes to high level at the trailing edge 173. The RDBL* signal thus goes to low level. The circuit then waits for the next leading edge 175 of the CLK_IO signal, and when the pulse 177 resulting therefrom arrives, gate 151 displays this pulse at its output R1*, causing gate 155 to release the latch, and first the signal Q* at the output of gate 155 goes to high level, and then as a result, the signal Q goes to low level.

Thus it has been seen how the drive terminal Q has been driven to high level and low level by both the conditions of the data from the databus read amplifier arriving before the clock, and with the data arriving after the clock. It will also be seen that the signal at the drive terminal has been synchronized with the clock. In the case of a race condition (latency 2), one or the other of the conditions noted above will occur, but the output drive terminal will still be driven high and low, and synchronized with the clock, no matter which condition occurs.

More importantly for this invention, it will be seen that for a latency of three, the data which had arrived prior to a clock pulse has been delayed by one clock cycle before being output, while for a latency of one, the data which had arrived after a clock pulse is output within the same clock cycle during which it had arrived.

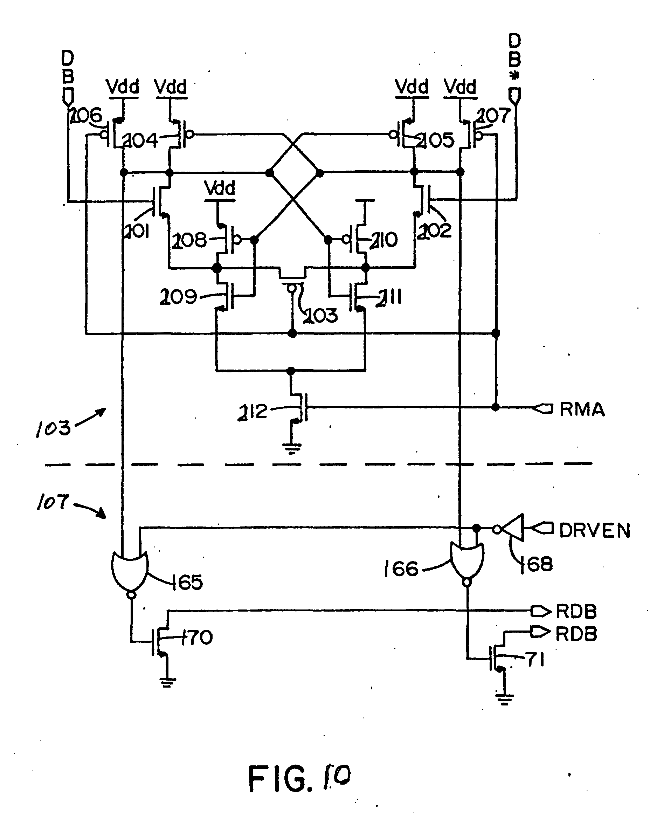

Figure 10 is a schematic diagram of the read amplifier 103 and of the driver stage 107 which is connected to the output of amplifier 103. The data bus leads DB (representing either DB0 or DB1) and DB* (representing either DB0* or DB1*) are connected to respective gates of n channel field effect transistors (FETs) 201 and 202. These transistors have their sources connected to the sources and drains respectively of p channel FET 203, 204, 205, 206, 207. The gate of FET 203 is connected to an RMA (representing either RMA0 or RMA1) lead, which receives a read command from control 105 (Figure 6). The drains of FETs 201 and 202 are connected to the sources of p channel FETs 204 and 205 respectively, which have their sources connected to a voltage source Vdd. The gates of FETs 204 and 205 are crosscoupled to the drains of transistors 201 and 202. P channel FETs 206 and 207 have their source and drain circuits connected in parallel with the source and drain circuits of FETs 204 and 205, and have their gates connected to the RMA lead.

An inverter comprised of p channel FET 208 having its source-drain circuit connected in series with the drain and source circuit of n channel FET 209 have their gates connected to the gate of FET 204, the source of FET 208 being connected to a source of voltage Vdd. Another inverter comprised of p channel FET 210 having its source-drain circuit connected in series with the drain and source circuit of n channel FET 211 have their gates connected to the gate of FET 205, the source of FET 210 being connected to the source of voltage Vdd. The sources of FETs 209 and 211 are connected together to the drain of an n channel FET 212, which has its source connected to ground, and its gate connected to the RMA lead.

Output leads of the above-described read amplifier 103 are connected from the drains of FETs 206 and 207 respectively to an input of respective NOR gates 165 and 166. Other inputs of NOR gates 165 and 166 are connected to the output of inverter 168, which has as its input a DRVEN lead from the control 105. The outputs of the NOR gates are connected to gates of n channel output FETs 170 and 171, which have their sources connected to ground. The drains of FETs 170 and 171 are connected to the RDB and RDB* leads respectively, which are the input leads to the RDB_CTRL circuit described earlier.

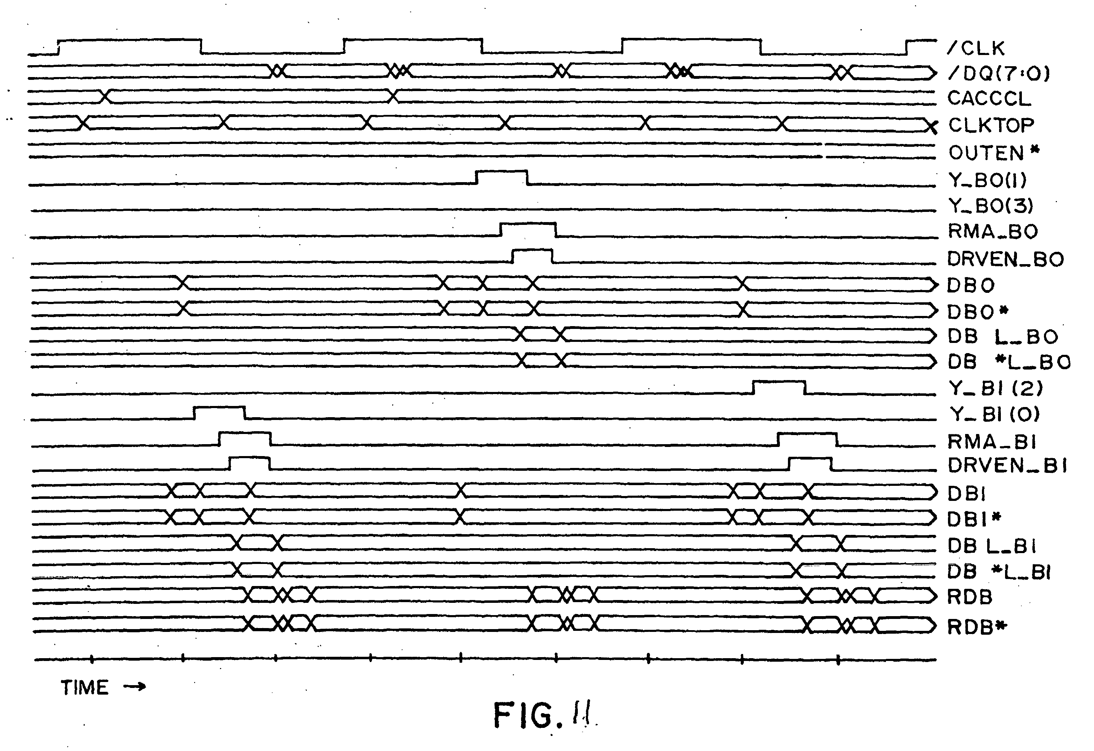

Reference is now made to Figure 11, which is a timing diagram for the latency of one case for an example of operation. While there is no clock input to the amplifier 103 or driver 107 circuits, the CLK timing is shown, with the first part of each successive cycle numbered in a circle, in order to obtain recognition of the data timing.

Data appears on the DB and DB* leads (timing waveforms DB1 and DB1*), wherein it may be seen that the data goes to high level after the beginning of clock cycle 1. Under control of the control 105, a high logic level read enable pulse is applied to the RMA lead (timing diagram RMA_B1), which causes FET 212 to conduct, and thus to connect the sources of transistors 202 and 211 to ground. The transistor pairs 208, 209 and 210, 211 sense the level connected to their drains, which level is established by the differential logic levels on the DB and DB* leads. Either of transistor pairs 201, 204 or 202, 205 thus conduct, causing the voltage Vdd to be extended to the gates of corresponding transistor pairs 208, 209 or 210, 211. With the RMA voltage applied to the gate of FETs 206 and 207, the transistors do not conduct, causing the Vss voltage to be extended to only one input of corresponding NOR gate 165 or 166.

In the meantime, the crosscoupled transistors latch, retaining the data signal therein.

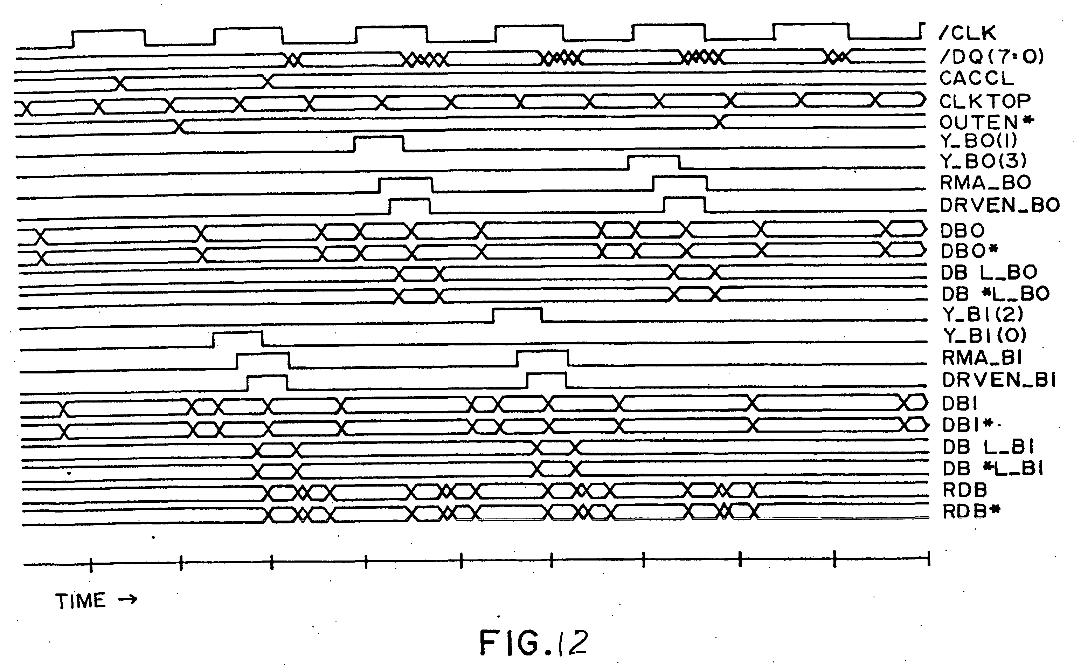

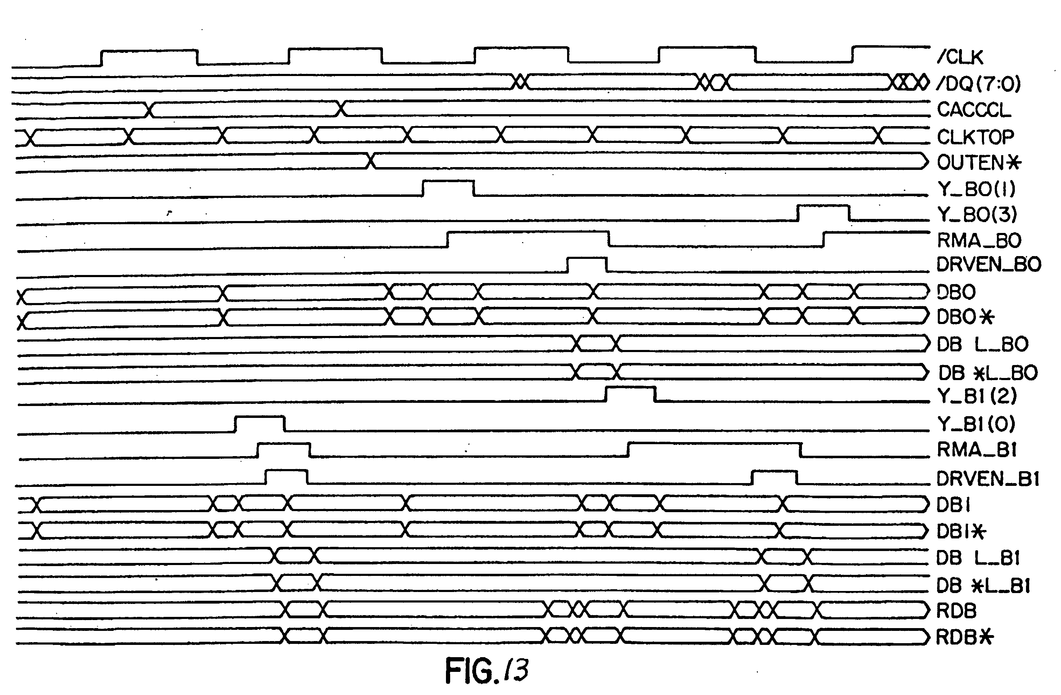

The timing of the various signals in the amplifier and driver stages for latency of one may be seen in Figure 11, the timing for latency of two may be seen in Figure 12, and the timing for latency of three may be seen in Figure 13. It may be seen that the logical data signal on the RDB and RDB* leads is retarded for one clock cycle relative to the case of a CAS latency of one.

In summary, considering the entire circuit, for latency of one the output buffer 111 is enabled and the data from amplifier 103 can pass directly to the output lead 113 (141). For the case of latency of two and three the output buffer 111 is not enabled, and data is stored in the latches 143 and 157 in the RDB_CTRL circuit.

For a latency of two, on the second clock cycle, the output buffer 111 is enabled, and data from the previous clock cycle is sent to the output lead 113 (121), and the RDB and RDB* leads are precharged. This is the signal for the control 105 that new data can be brought to latches 143 and 157, to wait there for the next clock cycle.

For a latency of three, the output buffer 111 is not enabled, and data from the second clock cycle is stored in the above-described latches in read amplifier 103. The portions of the RDB and RDB* lines that remain split (not precharged) extend that way for the interval of the enable signal of the read amplifiers. The data from the second clock cycle will be retained in the latches of the read amplifier for as long as the enable signal is true.

On the third clock cycle the output buffer 111 is enabled, allowing the data from the first clock cycle to pass to the output lead 113 (141). The RDB and RDB* leads now are precharged, signalling that the data from the second clock cycle can be transferred from the read amplifier to the RDB_CTRL circuit. In this manner the data from the third clock cycle can be placed in the read amplifiers and be retained there until it is moved to the RDB_CTRL circuit on the next clock cycle.

The cycle described above repeats itself on each clock cycle.

A person skilled in the art understanding the description above may now design alternative embodiments and variations using the principles described herein. All those falling within the scope of the claims appended hereto are considered to be part of the present invention.

## Claims

1. An output buffer for driving an output driver (64) of a synchronous random access memory (SRAM) circuit to either of opposite binary data values from a data source and a clock wherein the relative timing of data and clock signals is variable or uncertain, comprising:
(a) a source of data signals (RDB, RDB*),
(b) a clock source having pulses, one of which has a rising edge either being earlier than a leading edge of a data pulse of the data signals, being later than the leading edge of a data pulse, or being in a race condition with the data pulse,
(c) an externally controlled latency counter (1) for receiving clock signals from the clock source and for independently counting to a predetermined count value and for subsequently outputting a latent control signal (OUTENABLE), **characterised in that** the output buffer comprises:
(d) means for combining (11, 25, 31, 39) the latent control signal and the data pulse, and
(e) means (21) for providing an enabling signal to an output driver from the combining means which is in synchronization with the latent control signal, said enabling signal being synchronized to a specific predetermined edge of the clock.

2. An output buffer as defined in claim 1, in which the source of data signals (RDB, RDB*) is a databus read amplifier.

3. An output buffer as defined in claim 1 further including an output flip flop (49), means for driving opposite polarity data signals from the data pulse, and means for driving the flip flop (49) to one of two states by the opposite polarity data signals.

4. An output buffer as claimed in claim 1, for a synchronous dynamic random access memory (SDRAM) comprising:
(a) means for reading a pair of complementary data bus lines (23, 37),
(b) means for receiving an output signal of the reading means (25, 39),
(c) said latency counter further providing an output enable signal to the output buffer for outputting the output signal upon counting a predetermined number of clock pulses based on a predetermined latency, and
(d) means (27) for enabling the reading means (25, 39), the receiving means and the output buffer to pass data logic levels from the data bus lines to the output driver (62) within one clock cycle in the event of a latency of one, for delaying said data logic levels for one clock cycle in the event of a latency of two, and for delaying said data logic levels for two clock cycles in the event of a latency of three.

5. A circuit as defined in claim 4 in which the receiving means is comprised of first latch means (23, 37), means for enabling storage of the data logic levels in the latch means for one clock cycle in the event of a latency of two before providing the stored data logic levels to the output buffer.

6. A circuit as defined in claim 5 in which the reading means is comprised of second latch means (17, 19, 35), means for enabling storage of the data logic levels in the second latch means for one clock cycle before providing the stored data logic levels to the first latch means, and means for storage of the data logic levels provided to the first latch means for one clock cycle before providing the data logic levels stored in the first latch means to the output buffer, in the event of a latency of three.

7. A method of driving an output buffer of an SDRAM circuit to either of opposite binary data values from a data source and a clock wherein the relative timing of data and clock signals is variable or uncertain, comprising:
(a) in an externally controlled latency counter, independently counting clock signal pulses from a clock source, to a predetermined count value and subsequently outputting a latent control signal,
(b) combining the latent control signal and a pulse of a data signal which has a leading edge which is earlier, or later, or in a race with, a rising edge of a pulse of the clock signal,
(c) providing an enabling signal to an output driver after the combining step, which is in synchronization with the latent control signal, said enabling signal being synchronized to a specific predetermined edge of the clock.

## Patentansprüche

1. Ausgangspuffer zum Treiben eines Ausgangstreibers (64) einer synchronen Direktzugriffsspeicher-(SRAM)-Schaltung auf einen von entgegengesetzten Binärdatenwerten von einer Datenquelle und einem Takt, worin die relative Zeitsteuerung von Daten- und Taktsignalen variabel oder unbestimmt ist, mit:
(a) einer Quelle von Datensignalen (RDB, RDB*),
(b) einer Taktquelle mit Impulsen, von denen einer eine ansteigende Flanke hat, die entweder früher als eine Vorderflanke eines Datenimpulses der Datensignale ist, später als die Vorderflanke des Datenimpulses ist oder in unterschiedlicher Signaldurchlaufbedingung mit dem Datenimpuls ist,
(c) einem extern gesteuerten Latenz-Zähler (1) zum Empfangen von Taktsignalen von der Taktquelle und zum unabhängigen Zählen auf einen vorbestimmten Zählwert und zum nachfolgenden Abgeben eines Latent-Steuersignals (OUTENABLE), **dadurch gekennzeichnet, dass** der Ausgangspuffer aufweist:
(d) Mittel zum Kombinieren (11, 25, 31, 39) des Latent-Steuersignals und des Datenimpulses, und
(e) Mittel (21) zum Liefern eines Freigabesignals an einen Ausgangstreiber vom Kombiniermittel, das mit dem Latent-Steuersignal synchron ist, welches Freigabesignal mit einer spezifischen vorbestimmten Flanke des Taktes synchronisiert ist.

2. Ausgangspuffer nach Anspruch 1, in welchem die Quelle von Datensignalen (RDB, RDB*) ein Datenbus-Leseverstärker ist.

3. Ausgangspuffer nach Anspruch 1, ferner aufweisend ein Ausgangs-Flipflop (49), Mittel zum Treiben von Datensignalen entgegengesetzter Polarität vom Datenimpuls und Mittel zum Treiben des Flipflop (49) auf einen von zwei Zuständen durch die Datensignale entgegengesetzter Polarität.

4. Ausgangspuffer nach Anspruch 1, für einen synchronen dynamischen Direktzugriffsspeicher (SDRAM), aufweisend:
(a) Mittel zum Lesen eines Paars komplementärer Datenbusleitungen (23, 37),
(b) Mittel zum Empfangen eines Ausgangssignals der Lesemittel (25, 39),
(c) welcher Latenz-Zähler ferner ein Ausgabe-Freigabesignal an den Ausgangspuffer liefert, um das Ausgangssignal auf ein Zählen einer vorbestimmten Zahl von Taktimpulsen hin auf der Basis einer vorbestimmten Latenz abzugeben, und
(d) Mittel (27), um die Lesemittel (25, 39), das Empfangsmittel und den Ausgangspuffer freizugeben, um im Fall einer Latenz von Eins Datenlogikpegel von den Datenbusleitungen zum Ausgangstreiber (62) innerhalb eines Taktzyklus durchzulassen, um im Fall einer Latenz von Zwei die Datenlogikpegel um einen Taktzyklus zu verzögern und um im Fall einer Latenz von Drei die Datenlogikpegel um zwei Taktzyklen zu verzögern.

5. Schaltung nach Anspruch 4, in der das Empfangsmittel aus einem ersten Latch-Mittel (23, 37) besteht, einem Mittel zum Freigeben einer Speicherung der Datenlogikpegel im Latch-Mittel für einen Taktzyklus im Fall einer Latenz von Zwei, bevor die gespeicherten Datenlogikpegel an den Ausgangspuffer geliefert werden.

6. Schaltung nach Anspruch 5, in der das Lesemittel aus einem zweiten Latch-Mittel (17, 19, 35) besteht, einem Mittel, um eine Speicherung der Datenlogikpegel im zweiten Latch-Mittel für einen Taktzyklus freizugeben, bevor die gespeicherten Datenlogikpegel an das erste Latch-Mittel geliefert werden, und Mittel zur Speicherung der an das erste Latch-Mittel gelieferten Datenlogikpegel für einen Taktzyklus, bevor die im ersten Latch-Mittel gespeicherten Datenlogikpegel an den Ausgangspuffer geliefert werden, im Fall einer Latenz von Drei.

7. Verfahren zum Treiben eines Ausgangspuffers einer SDRAM-Schaltung auf einen von entgegengesetzten Binärdatenwerten von einer Datenquelle und einem Takt, worin die relative Zeitsteuerung von Daten- und Taktsignalen variabel oder unbestimmt ist, aufweisend:
(a) in einem extern gesteuerten Latenz-Zähler, unabhängiges Zählen von Taktsignalimpulsen von einer Taktquelle auf einen vorbestimmten Zählwert und nachfolgendes Abgeben eines Latent-Steuersignals,
(b) Kombinieren des Latent-Steuersignals und eines Impulses eines Datensignals, das eine Vorderflanke hat, die früher oder später als oder in unterschiedlicher Signaldurchlaufbedingung zu einer ansteigenden Flanke eines Impulses des Taktsignals ist,
(c) Liefern eines Freigabesignals an einen Ausgangstreiber nach dem Kombinierschritt, das mit dem Latent-Steuersignal synchron ist, welches Freigabesignal mit einer spezifischen vorbestimmten Flanke des Taktes synchronisiert ist.

## Revendications

1. Tampon de sortie destiné à amener un dispositif de commande de sortie (64) d'un circuit de SRAM, ou mémoire vive synchrone, sur l'une ou l'autre de valeurs de données binaires opposées à partir d'une source de données et d'un signal d'horloge, où le positionnement temporel relatif des données et des signaux d'horloge n'est pas variable ou incertain, comprenant :
(a) une source de signaux de données (RDB, RDB*),
(b) une source de signaux d'horloge possédant des impulsions, dont l'une présente un flanc montant qui est ou bien antérieur au flanc avant d'une impulsion de données des signaux de données, ou bien postérieur au flanc avant d'une impulsion de données, ou bien en situation de compétition avec l'impulsion de données,
(c) un compteur de temps de latence extérieurement commandé (1) servant à recevoir des signaux d'horloge de la part de la source de signaux d'horloge, et destiné à compter indépendamment jusqu'à une valeur de comptage prédéterminée et à délivrer ensuite un signal de commande latent (OUTENABLE),
le tampon de sortie étant **caractérisé en ce qu'**il comprend :
(d) un moyen servant à combiner (11, 25, 31, 39) le signal de commande latent et l'impulsion de données, et
(e) un moyen (21) servant à fournir un signal de validation à un dispositif de commande de sortie à partir du moyen de combinaison qui est en synchronisation avec le signal de commande latent, ledit signal de validation étant synchronisé avec un flanc prédéterminé spécifique du signal d'horloge.

2. Tampon de sortie selon la revendication 1, où la source des signaux de données (RDB, RDB*) est un amplificateur de lecture de bus de données.

3. Tampon de sortie selon la revendication 1, comportant en outre une bascule de sortie (49), un moyen servant à commander des signaux de données de polarités opposées à partir de l'impulsion de données, et un moyen servant à amener la bascule (49) sur l'un de deux états par les signaux de données de polarités opposées.

4. Tampon de sortie selon la revendication 1, pour mémoire vive dynamique synchrone (SDRAM), comprenant :
(a) un moyen servant à lire une paire de lignes de bus de données complémentaires (23, 37),
(b) un moyen servant à recevoir un signal de sortie du moyen de lecture (25, 39),
(c) ledit compteur de temps de latence fournissant en outre un signal de validation de sortie au tampon de sortie afin de délivrer le signal de sortie au moment du comptage d'un nombre prédéterminé d'impulsions d'horloge se basant sur un temps de latence prédéterminé, et
(d) un moyen (27) servant à valider le moyen de lecture (25, 39), le moyen de réception et le tampon de sortie afin de faire passer des niveaux logiques de données, des lignes de bus de données au dispositif de commande de sortie (62), en restant à l'intérieur d'un unique cycle d'horloge dans le cas d'un temps de latence de "un", servant à retarder lesdits niveaux logiques de données pendant un cycle d'horloge dans le cas d'un temps de latence de "deux", et servant à retarder lesdits niveaux logiques de données pendant deux cycles d'horloge dans le cas d'un temps de latence de "trois".

5. Circuit selon la revendication 4, où le moyen de réception est constitué d'un premier moyen de verrouillage (23, 37), d'un moyen servant à valider le stockage des niveaux logiques de données dans le moyen de verrouillage pendant un cycle d'horloge dans le cas d'un temps de latence de "deux" avant de fournir les niveaux logiques de données stockés au tampon de sortie.

6. Circuit selon la revendication 5, où le moyen de lecture est constitué d'un deuxième moyen de verrouillage (17, 19, 35), d'un moyen servant à valider le stockage des niveaux logiques de données dans le deuxième moyen de verrouillage pendant un cycle d'horloge avant de fournir les niveaux logiques de données stockés au premier moyen de verrouillage, et un moyen servant à stocker les niveaux logiques de données fournis au premier moyen de verrouillage pendant un cycle d'horloge avant de foumir les niveaux logiques de données stockés dans le premier moyen de verrouillage au tampon de sortie, dans le cas d'un temps de latence de "trois".

7. Procédé permettant d'amener un tampon de sortie d'un circuit SDRAM sur l'une ou l'autre de valeurs de données binaires opposées à partir d'une source de données et d'un signal d'horloge, où le positionnement temporel relatif des données et des signaux d'horloge est variable ou incertain, comprenant les opérations suivantes :
(a) dans un compteur de temps de latence extérieurement commandé, compter indépendamment des impulsions de signal d'horloge venant d'une source de signaux d'horloge jusqu'à une valeur de comptage prédéterminée, et délivrer ensuite un signal de commande latent,
(b) combiner le signal de commande latent et une impulsion d'un signal de données qui présente un flanc avant qui est antérieur, ou postérieur, ou encore en situation de compétition, par rapport à un flanc montant d'une impulsion du signal d'horloge,
(c) foumir un signal de validation à un dispositif de commande de sortie après l'opération de combinaison, qui est en synchronisation avec le signal de commande latent, le signal de validation étant synchronisé avec un flanc prédéterminé spécifique du signal d'horloge.
